# EUROPÄISCHE PATENTSCHRIFT

(11) **EP 0 896 761 B1**
(45) Veröffentlichungstag und Bekanntmachung des Hinweises auf die Patenterteilung: **01.08.2001**
(21) Anmeldenummer: 97921623.1
(22) Anmeldetag: 21.04.1997
(51) Int. Cl.: H03B 5/36

(54) **INTEGRIERTE TAKTERZEUGUNGSSCHALTUNG**
INTEGRATED CLOCK-SIGNAL GENERATING CIRCUIT
CIRCUIT INTEGRE DE GENERATION DE SIGI

(30) Priorität: 29.04.1996 DE 19617174
(43) Veröffentlichungstag der Anmeldung: 17.02.1999
(73) Patentinhaber: Infineon Technologies AG, 81669 München (DE)
(72) Erfinder: WAGNER, Wolfgang, D-81539 München (DE)
(74) Vertreter: Zedlitz, Peter, Dipl.-Inf.
(86) Internationale Anmeldenummer: DE9700796
(87) Internationale Veröffentlichungsnummer: WO9741635

(56) Entgegenhaltungen:
- US-A- 4 321 562
- US-A- 4 571 558
- US-A- 5 550 489
- PATENT ABSTRACTS OF JAPAN vol. 010, no. 356 (E-459), 29.November 1986 & JP 61 154153 A (MATSUSHITA ELECTRONICS CORP), 12.Juli 1986,
- PATENT ABSTRACTS OF JAPAN vol. 012, no. 420 (E-679), 8.November 1988 & JP 63 157509 A (MATSUSHITA ELECTRONICS CORP), 30.Juni 1988,
- IEEE TRANSACTIONS ON CIRCUITS AND SYSTEMS, Bd. 37, Nr. 2, 1.Februar 1990, Seiten 175-182, XP000127769 NORDHOLT E H ET AL: ""SINGLE-PIN" INTEGRATED CRYSTAL OSCILLATORS"

## Beschreibung

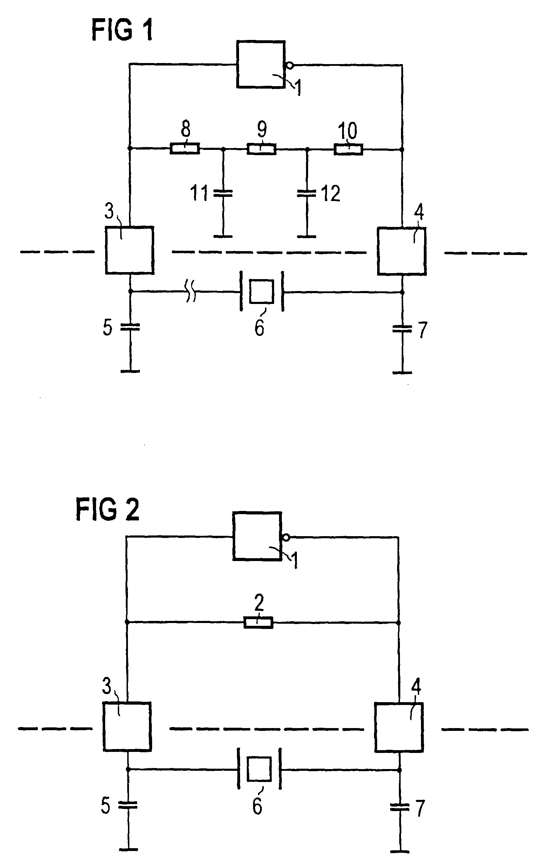

Viele integrierte Schaltungen, wie z.B. Mikrocontroller, bei denen neben einem Mikroprozessor eine Vielzahl von Peripherieeinheiten mitintegriert sind, besitzen einen Oszillator, der zum Anschluß eines Quarzes geeignet ist. Aus dem Siemens Datenbuch "Microcomputer Components", Microcontrollers, Data Catalog 1988, ist auf Seite 78 in der unteren linken Figur dargestellt, wie ein derartiger Oszillator mit einem Quarz extern zu beschalten ist. Figur 2 der vorliegenden Erfindung zeigt den zusätzlichen internen Schaltungsteil. Mit 1 ist ein Inverter bezeichnet, der zwischen Anschlußklemmen 3 und 4 geschaltet ist. Parallel zu diesem Inverter 1 ist ein Widerstand 2 geschaltet. Diese beiden Elemente sind in einem Mikrocontroller mitintegriert. Der integrierte Teil der Schaltung befindet sich in der oberen Hälfte der Figur und ist durch die gestrichelte Linie vom externen Teil in der unteren Hälfte der Figur getrennt. Extern wird zwischen die Anschlußklemmen 3 und 4 ein Quarz 6 geschaltet, sowie jeweils zwischen der Anschlußklemme 3 und Masse sowie der Anschlußklemme 4 und Masse eine Kapazität 5 bzw. 7.

In der US 4,571,558 ist eine Quarzoszillatorschaltung beschrieben, die im Rückkopplungszweig des Inverters zwei Integratoren enthält, die zusammen eine Phasenverschiebung von 180° bewirken. Durch diese Phasenverschiebung um 180° wird bewirkt, daß das Schwingungsverhalten des Oszillators eine geringere Temperaturabhängigkeit sowie eine geringere Abhängigkeit von Herstellungstolleranzen aufweist. Eine weitere gattungsgemäße Schaltungsanordnung mit einem Quarzoszillator ist in der US 4,321,562 beschrieben.

Mit steigenden Leistungsanforderungen werden Mikrocontroller mit immer höheren Frequenzen betrieben. Deswegen müssen die Quarzscheiben immer dünner werden, wodurch die Bruchgefahr steigt. Dies gilt insbesondere aufgrund von Erschütterungen im Automobilbereich, wo derartige Mikrocontroller zur Motorsteuerung, ABS-Steuerung oder dergleichen eingesetzt werden. Ein solcher Quarzbruch führt zum Stillstand des Oszillators und damit auch zum Ausfall des gesamten Systems. Um dies zu vermeiden wird oft ein sogenannter Nottakt gefordert, der durch zusätzlichen Schaltungsaufwand ermöglicht wird.

Aus der EP 286 879 ist eine integrierte Schaltungsanordnung zur Überwachung eines mitintegrierten Oszillators bekannt, bei der ein integrierter Oszillator über ein externes Frequenznormal angeregt wird. Ein zweiter integrierter Reserveoszillator erzeugt einen langsameren Hilfstakt, der ständig mit dem Oszillatortakt verglichen wird, und der Systemtakt wird dann aus dem schnelleren Takt gewonnen. Fällt der Quarz z.B. durch Quarzbruch aus, so wird auf den Reserveoszillator umgeschaltet.

Eine weitere Möglichkeit besteht darin eine PLL zur Systemtakterzeugung zu verwenden, welche eine minimale Frequenz aufweist, welche abhängig von der minimalen Frequenz des spannungsgesteuerten Oszillators der PLL ist. Bei einem Quarzbruch fällt dann die Frequenz des Systemtakts auf die minimale Frequenz der PLL zurück. Ein weiterer Vorteil einer PLL besteht darin, daß die Oszillatorfrequenz um Faktoren kleiner sein kann als der Systemtakt, wodurch dickere und damit bruchsichere Quarze zum Einsatz kommen.

Nachteil aller dieser Anordnungen ist der relativ hohe Schaltungsaufwand.

Aufgabe der vorliegenden Erfindung ist es daher, eine Schaltungsanordnung mit einem Quarzoszillator anzugeben, die bei einem Quarzbruch einen Nottakt erzeugt und schaltungstechnisch auf einfache Weise realisierbar ist.

Diese Aufgabe wird durch den kennzeichnenden Teil des Anspruchs 1 gelöst. Weiterbildungen sind Kennzeichen der Unteransprüche.

Die Erfindung wird nachfolgend anhand einer weiteren Figur näher erläutert.

Es zeigen
- Figur 1: ein Prinzipschaltbild der erfindungsgemäßen Schaltungsanordnung und
- Figur 2: ein Prinzipschaltbild gemäß dem Stand der Technik.

Prinzip der vorliegenden Erfindung ist es, in den Rückkopplungszweig des Inverters ein phasendrehendes Bauelement oder Schaltungsteil einzufügen, welches eine Phasendrehung um 180° bewirkt. Dadurch kann auf einfache Weise der integrierte Oszillator weiter schwingen.

In der in Figur 1 dargestellten Anordnung ist nun anstelle des Widerstands 2 gemäß Figur 2 eine Reihenschaltung aus drei Widerständen 8, 9 und 10 vorgesehen, die zwischen die Eingangsklemmen 3 und 4 geschaltet sind. Am Knotenpunkt zwischen Widerstand 8 und Widerstand 9 ist der erste Anschluß einer Kapazität 11 verbunden, dessen anderer Anschluß mit Masse verschaltet ist. Ebenso ist am Knotenpunkt der Widerstände 9 und 10 eine weitere Kapazität 12 angeschlossen, deren zweiter Anschluß ebenfalls mit Masse verbunden ist.

Die Oszillatorschaltung gemäß Figur 1 bzw. Figur 2 stellt eine typische Oszillatorschaltung dar, welche üblicherweise aus einem Inverter und einem Rückkoppelelement, z.B. einem Widerstand oder sehr hochohmigen Transistoren in der Größenordnung von 100 KΩ bis 1 MΩ bestehen. Extern sind nur ein Quarz 6 und die beiden Kapazitäten 5 und 7 notwendig.

In Figur 1 ist durch die unterbrochene Linie in der Anschlußleitung des Quarzes 6 an der Anschlußklemme 3 beispielsweise der Bruch des Quarzes dargestellt, wodurch bei üblichen Anordnung gemäß Figur 2 die Bedingungen für eine Oszillation nicht mehr gegeben sind. Durch das Einfügen der Elemente 8 bis 12 in den Rückkopplungszweig des Inverters 1 findet nun jedoch eine Phasendrehung um 180° statt, so daß die Oszillation wieder einsetzen kann. Die Ausgangsfrequenz unterscheidet sich dann jedoch erheblich von der normalerweise erzeugten und dies kann durch den Mikrocontroller erkannt werden, so daß entsprechende Notmaßnahmen getroffen werden können. Die RC-Glieder 8 bis 12 stellen dabei die einfachste Art der Phasendrehung dar. Da ein einzelnes RC-Glied 8, 9 bzw. 9, 12 nur um 90° dreht, sind also mindestens zwei RC-Glieder notwendig. Um dies zu erreichen, wird im vorliegenden Fall der ursprüngliche Widerstand 2 in drei Teilwiderstände 8, 9, 10 unterteilt und dazwischen jeweils die Kondensatoren 11 und 12 geschaltet.

Auf diese Weise kann mit nur zwei zusätzlichen integrierten Kondensatoren das Weiterschwingen des Oszillators auf einer "Notfrequenz" gewährt werden und so wird auf diese Weise ein Ersatztakt bei Quarzbruch bereitgestellt.

## Patentansprüche

1. Integrierte Schaltungsanordnung mit einem Quarzoszillator zur Erzeugung eines Betriebstaktes,
- mit einem extern zu beschaltenden Quarz (6) zur Erzeugung einer Phasendrehung von 180° und
- mit einem integrierten Inverter (1) zur Erzeugung einer weiteren Phasendrehung von 180°, dessen Eingang und Ausgang mit dem ersten und zweiten Anschluß (3, 4) des externen Quarzes (6) verbunden ist,
- die somit zusammen eine Gesamtphasendrehung von 360° bewirken,
**dadurch gekennzeichnet,** daß
- in einem Rückkopplungszweig des integrierten Inverters (1) ein mitintegrierter, phasendrehender Schaltungsteil (8, 9, 10, 11, 12) geschaltet ist, der ebenfalls eine Phasendrehung um 180° bewirkt und bei einem Ausfall des Betriebstaktes einen Nottakt erzeugt.

2. Integrierte Schaltungsanordnung nach Anspruch 1,
**dadurch gekennzeichnet,** daß
der mitintegrierte Phasenschieberoszillator (8, 9, 10, 11, 12) eine Vielzahl von RC-Glieder enthält, die derart dimensioniert sind, daß diese RC-Glieder in Summe eine Phasendrehung von 180° bewirken.

3. Integrierte Schaltungsanordnung nach einem der vorhergehenden Ansprüche,
**dadurch gekennzeichnet,** daß
der mitintegrierte Phasenschieberoszillator (8, 9, 10, 11, 12) aus drei in Reihe geschalteten Widerständen (8, 9, 10) besteht, wobei zwischen den beiden Knotenpunkten der Reihenschaltung der Widerstände (8, 9, 10) und einem Bezugspotential jeweils eine Kapazität (11, 12) geschaltet ist.

## Claims

1. Integrated circuit arrangement having a crystal oscillator for producing an operating clock signal,
- having a crystal (6), to be wired up externally, for producing a phase shift of 180°, and
- having an integrated invertor (1) for producing a further phase shift of 180°, the input and the output of said invertor being connected to the first and the second connection (3, 4) of the external crystal (6),
- which thus together effect an overall phase shift of 360°,
characterized in that
- a feedback path of the integrated invertor (1) contains a phase-shifting circuit section (8, 9, 10, 11, 12) which is additionally integrated, likewise effects a phase shift through 180° and produces an emergency clock signal if the operating clock signal fails.

2. Integrated circuit arrangement according to Claim 1,
characterized in that
the phase-shifting oscillator (8, 9, 10, 11, 12) which is additionally integrated contains a multiplicity of RC elements which are dimensioned such that these RC elements in total effect a phase shift of 180°.

3. Integrated circuit arrangement according to one of the preceding claims,
characterized in that
the phase-shifting oscillator (8, 9, 10, 11, 12) which is additionally integrated comprises three resistors (8, 9, 10) connected in series, and in each case one capacitor (11, 12) is connected between the two node points of the series-connected resistors (8, 9, 10) and a reference-ground potential.

## Revendications

1. Circuit intégré comprenant un oscillateur à quartz pour générer un signal d'horloge de fonctionnement,
- avec un quartz (6) à montage externe pour créer une rotation de phase de 180° et
- avec un inverseur intégré (1) pour créer une autre rotation de phase de 180°, dont l'entrée et la sortie sont reliées à la première et la deuxième borne (3, 4) du quartz (6) externe,
- qui produisent ainsi conjointement une rotation de phase totale de 360°,
caractérisé en ce qu'un élément de circuit (8, 9, 10, 11, 12) provoquant une rotation de phase et inscrit dans le circuit intégré est monté dans une branche de rétroaction de l'inverseur intégré (1), élément qui produit lui aussi une rotation de phase de 180° et génère un signal d'horloge de secours en cas de défaillance du signai d'horloge de fonctionnement.

2. Circuit intégré selon la revendication 1, caractérisé en ce que l'oscillateur déphaseur (8, 9, 10, 11, 12) inscrit dans le circuit intégré contient une pluralité d'éléments RC qui sont dimensionnés de telle sorte que la somme de ces éléments RC produit une rotation de phase de 180°.

3. Circuit intégré selon l'une des revendications précédentes, caractérisé en ce que l'oscillateur déphaseur (8, 9, 10, 11, 12) inscrit dans le circuit intégré est composé de trois résistances (8, 9, 10) montées en série, dans lequel une capacité (11, 12) est à chaque fois montée entre les deux points de jonction du montage en série des résistances (8, 9, 10) et un potentiel de référence.
